# EUROPÄISCHE PATENTANMELDUNG

(11) **EP 2 736 308 A1**
(43) Veröffentlichungstag der Anmeldung: **28.05.2014**
(21) Anmeldenummer: 12193809.6
(22) Anmeldetag: 22.11.2012
(51) Int. Cl.: H05K 1/02, H01L 23/36

(54) **Kühlkörperanordnung**

(71) Anmelder: Siemens Aktiengesellschaft, 80333 München (DE)
(72) Erfinder: Reischer, Wilhelm, 1210 Wien (AT)

(57) **Zusammenfassung**

Die Erfindung betrifft eine Kühlkörperanordnung mit einem Kühlkörper (1), welcher zumindest eine Lötfahne (3, 5) umfasst, welche in einen Durchbruch (4, 6) einer kupferkaschierten Leiterplatte (2) mittels eines Schwallverfahrens eingelötet ist, wobei der Kühlkörper (1) aus einem Aluminiumkörper besteht und wobei wenigstens die Lötfahne (3, 5) ausschließlich mit einer Nickelschicht überzogen ist. Gegenüber der gängigen Lehre nach dem Stand der Technik entfällt der Arbeitsschritt des Verzinnens, sodass die Kühlkörperanordnung günstiger und schneller herzustellen ist.

## Beschreibung

Die Erfindung betrifft eine Kühlkörperanordnung mit einem Kühlkörper, welcher zumindest eine Lötfahne umfasst, welche in einem Durchbruch einer kupferkaschierten Leiterplatte mittels eines Schwallverfahrens eingelötet ist. Zudem betrifft die Erfindung ein Montageverfahren zur Herstellung der Kühlkörperanordnung.

Zur Kühlung elektronischer Bauelemente auf Leiterplatten kommen Kühlkörper zur Anwendung. Vorzugsweise umfasst ein Kühlkörper zumindest eine Lötfahne, welche in einer Bohrung einer kupferkaschierter Leiterplatte eingelötet ist. Auf diese Weise ist eine beanspruchbare, formschlüssige mechanische Verbindung zwischen Leiterplatte und Kühlkörper sichergestellt. Darüber hinaus besteht durch das Einlöten eine elektrische Kontaktierung des Kühlkörpers mit einem Lötauge der Leiterplatte. Über eine Leiterbahn, die mit dem Lötauge verbunden ist, ist eine direkte elektrische Verbindung mit einem am Kühlkörper angebrachten Bauelement möglich.

Einlötbare Kühlkörper sind in der Regel aus Kupfer gefertigt. Bei diesem Material sind diverse Lötverfahren anwendbar, um eine qualitativ hochwertige Lötverbindung zwischen Kühlkörper und Leiterplatte herzustellen. Der Werkstoff Kupfer ist jedoch teuer, weshalb in Fällen mit geringeren Kühlanforderungen zunehmend Aluminium als Kühlkörpermaterial zum Einsatz kommt.

Um auch hier eine qualitativ hochwertige Lötverbindung zwischen Kühlkörper und Leiterplatte sicherzustellen, wird ein Aluminiumkühlkörper nach dem Stand der Technik mit einer Zinnoberfläche versehen. Ein direktes Verzinnen von Aluminium ist jedoch problematisch, weshalb oftmals vor dem Verzinnen eine Vernickelung des Aluminiumkühlkörpers erfolgt. Damit sind zwei Oberflächenbehandlungen notwendig, um nach dem Stand der Technik eine gattungsgemäße Kühlkörperanordnung herzustellen.

Der Erfindung liegt die Aufgabe zugrunde, für eine Kühlkörperanordnung der eingangs genannten Art eine Verbesserung gegenüber dem Stand der Technik anzugeben.

Erfindungsgemäß wird diese Aufgabe gelöst durch eine Anordnung gemäß Anspruch 1 und ein Verfahren gemäß Anspruch 8. Verbesserungen sind in abhängigen Ansprüchen ausgeführt.

Dabei besteht der Kühlkörper aus einem Aluminiumkörper, wobei wenigstens die Lötfahne ausschließlich mit einer Nickelschicht überzogen ist. Entgegen der gängigen Lehre nach dem Stand der Technik hat sich in Lötversuchen der Anmelderin gezeigt, dass überraschenderweise auch ein ausschließlich vernickelter Aluminiumkühlkörper mit einer kupferkaschierten Leiterplatte mittels Schwallverfahrens verlötbar ist. Die entstehende Lötverbindung ist stabil und beanspruchbar. Auch Rüttelbelastungen, wie sie bei elektrischen oder elektronischen Geräten vorkommen, hält die erfindungsgemäße Verbindung stand. Es entfällt der Arbeitsschritt des Verzinnens, sodass die Kühlkörperanordnung günstiger und schneller herzustellen ist.

Vorteilhafterweise ist der gesamte Aluminiumkörper ausschließlich mit einer Nickelschicht überzogen. Insbesondere bei geringen Abmessungen des Aluminiumkörpers ist es herstellungstechnisch einfacher, den gesamten Aluminiumköper zu vernickeln.

In einer Ausprägung der Erfindung ist der Aluminiumkörper aus Aluminiumblech gefertigt. Ein derartiger Aluminiumkörper wird in einem Arbeitsschritt ausgestanzt, einschließlich der zumindest einen Lötfahne.

Dabei ist es günstig, wenn der Aluminiumkörper aus einem abgekanteten Aluminiumblech gefertigt ist und zumindest zwei Lötfahnen aufweist, die in zwei Durchbrüchen der Leiterplatte eingelötet sind. Damit wird im verlöteten Zustand eine besonders stabile Anordnung geschaffen.

Eine weitere Verbesserung sieht vor, dass der Kühlkörper mittels des Schwallverfahrens unter Verwendung eines sogenannten No Clean Flussmittels der Klasse L0 mit der Leiterplatte verlötet ist. Auch unter diesen Bedingungen ist die ausschließlich vernickelte Oberfläche des Kühlkörpers mit guter Qualität verlötbar, wobei aufgrund des verwendeten No Clean Flussmittels keine nachträgliche Reinigung erforderlich ist.

Günstigerweise weist die Nickelschicht eine Dicke zwischen 2µm und 10µm, vorzugsweise zwischen 2µm und 5µm, auf. Eine derartige Nickelschicht ist mit gängigen Verfahren einfach herstellbar und für das Schwallverfahren ausreichend dick.

Von Vorteil ist es zudem, wenn der Kühlkörper als Kühlkomponente eines Schaltnetzteils ausgebildet ist. Die Kühlanforderungen und Platzverhältnisse in Schaltnetzteilen sind derart, dass die Verwendung der erfindungsgemäßen Kühlkörperanordnung begünstigt ist. Auch den mechanischen Beanspruchungen, welchen solche Geräte ausgesetzt sind, hält die erfindungsgemäße Kühlkörperanordnung mit der erforderlichen Sicherheit stand.

Zur Herstellung der Kühlkörperanordnung ist ein Montageverfahren vorgesehen, bei dem in einem ersten Verfahrensschritt der Kühlkörper auf der Leiterplatte platziert wird, wobei die zumindest eine Lötfahne in den dazugehörenden Durchbruch der Leiterplatte eingeführt wird und bei dem in einem zweiten Verfahrensschritt die Lötfahne mittels Schwallverfahrens in dem Durchbruch eingelötet wird. Somit sind nur wenige Verfahrensschritte notwendig, um eine qualitativ hochwertige Kühlkörperanordnung herzustellen.

Wie oben dargelegt wird das Schwallverfahren günstigerweise mittels eines No Clean Flussmittels der Klasse L0 durchgeführt.

Die Erfindung wird nachfolgend in beispielhafter Weise unter Bezugnahme auf die beigefügte Figur erläutert. Es zeigt in schematischer Darstellung:

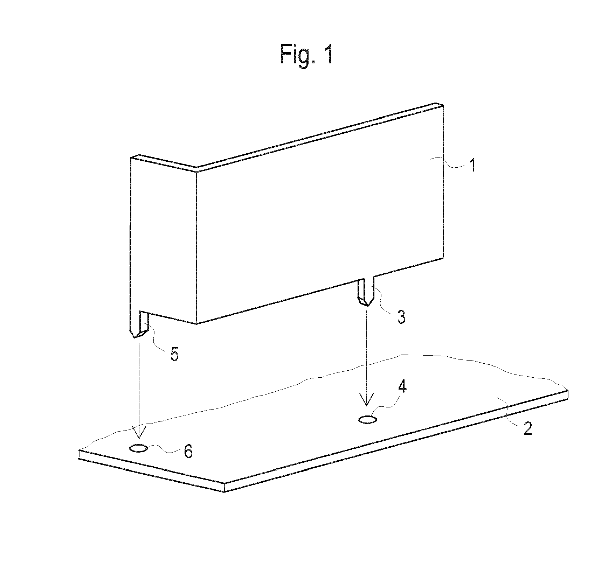

Fig. 1 Explosionsdarstellung einer Kühlkörperanordnung

Ein Kühlkörper 1 ist günstigerweise aus einem Aluminiumblech gestanzt und weist beispielsweise zwei Lötfahnen 3, 5 auf. Überzogen ist der Kühlkörper ausschließlich mit einer Nickelschicht.

Zur Anordnung des Kühlkörpers 1 auf einer kupferkaschierten Leiterplatte 2 weist diese zwei Durchbrüche 4, 6 auf. Diese Durchbrüche 4, 6 sind günstigerweise durchkontaktiert, um die Fläche für die Lötverbindung mit den Lötfahnen 3, 5 zu vergrößern. Einfacherweise können auch nur Lötaugen zur Verlötung mit den Lötfahnen 3, 5 des Kühlkörpers 1 vorgesehen sein. Ausgeführt sind die Durchbrüche 4, 6 beispielsweise als Bohrungen oder als eckige Löcher.

Der Kühlkörper 1 ist gekantet, mit einem kürzeren Schenkel und einem längeren Schenkel, wobei die Kontaktierung mit der Leiterplatte 2 stirnseitig erfolgt. An jedem Schenkel ist eine Lötfahne 3, 5 angeordnet. Der längere Schenkel ist günstigerweise zur Anbringung eines zu kühlenden Bauelements vorgesehen. Der kürzere Schenkel dient als Stütze, um im verlöteten Zustand auf den längeren Schenkel wirkende Normalkräfte aufzunehmen. Eine derartige Anordnung ist mechanisch stabil und widerstandsfähig gegen Rüttel- und Schwingungsbeanspruchungen.

Nachdem die Lötfahnen 3, 5 des Kühlkörpers 1 in die Durchbrüche 5, 6 der Leiterplatte 2 eingeführt worden sind, erfolgt die Verlötung mittels Schwallverfahrens. Dieses Verfahren kommt üblicherweise bei einer automatisierten Fertigung einer bestückten Leiterplatte zur Anwendung. Der Kühlkörper 1 wird dabei in einem Arbeitsschritt gemeinsam mit anderen auf der Leiterplatte 2 platzierten Bauelementen verlötet.

Durch die Verwendung eines No Clean Flussmittels der Klasse L0 ist keine nachträgliche Reinigung erforderlich, sodass insgesamt eine einfache Fertigung mit wenigen Arbeitsschritten gegeben ist.

Die Klasse L0 sagt aus, dass es sich um ein Flussmittel mit geringer Wirksamkeit (Low) und einem Halogenidanteil < 0,05% (< 500ppm) handelt. Solche Flussmittel ergeben bei Schwalllötverfahren qualitativ hochwertige Lötergebnisse.

Die Erfindung umfasst auch solche Kühlkörper 1, die nicht aus Blech hergestellt sind. Beispielsweise besteht der Kühlkörper 1 aus einem quaderförmigen Grundkörper, an dem separate Lötfahnen 3, 5 befestigt sind. Der Kühlkörper 1 muss lediglich dergestalt sein, dass eine Verlötung mit der kupferkaschierten Leiterplatte 2 mittels Schwallverfahrens durchführbar ist.

## Patentansprüche

1. Kühlkörperanordnung mit einem Kühlkörper (1), welcher zumindest eine Lötfahne (3, 5) umfasst, welche in einem Durchbruch (4, 6) einer kupferkaschierten Leiterplatte (2) mittels eines Schwallverfahrens eingelötet ist, **dadurch gekennzeichnet, dass** der Kühlkörper (1) aus einem Aluminiumkörper besteht und dass wenigstens die Lötfahne (3, 5) ausschließlich mit einer Nickelschicht überzogen ist.

2. Kühlkörperanordnung nach Anspruch 1, **dadurch gekennzeichnet, dass** der gesamte Aluminiumkörper ausschließlich mit einer Nickelschicht überzogen ist.

3. Kühlkörperanordnung nach Anspruch 1 oder 2, **dadurch gekennzeichnet, dass** der Aluminiumkörper aus Aluminiumblech gefertigt ist.

4. Kühlkörperanordnung nach Anspruch 3, **dadurch gekennzeichnet, dass** der Aluminiumkörper aus einem abgekanteten Aluminiumblech gefertigt ist und zumindest zwei Lötfahnen (3, 5) aufweist, die in zwei Durchbrüchen (4, 6) der Leiterplatte (2) eingelötet sind.

5. Kühlkörperanordnung nach einem der Ansprüche 1 bis 4, **dadurch gekennzeichnet, dass** der Kühlkörper (1) mittels des Schwallverfahrens unter Verwendung eines sogenannten No Clean Flussmittels der Klasse L0 mit der Leiterplatte (2) verlötet ist.

6. Kühlkörperanordnung nach einem der Ansprüche 1 bis 5, **dadurch gekennzeichnet, dass** die Nickelschicht eine Dicke zwischen 2µm und 10µm, vorzugsweise zwischen 2µm und 5µm, aufweist.

7. Kühlkörperanordnung nach einem der Ansprüche 1 bis 6, **dadurch gekennzeichnet, dass** der Kühlkörper (1) als Kühlkomponente eines Schaltnetzteils ausgebildet ist.

8. Montageverfahren zur Herstellung einer Kühlkörperanordnung nach einer der Ansprüche 1 bis 7, **dadurch gekennzeichnet, dass** in einem ersten Verfahrensschritt der Kühlkörper (1) auf der Leiterplatte (2) platziert wird, wobei die zumindest eine Lötfahne (3, 5) in den dazugehörenden Durchbruch (4, 6) der Leiterplatte (2) eingeführt wird und dass in einem zweiten Verfahrensschritt die Lötfahne (3, 5) mittels Schwallverfahrens in dem Durchbruch (4, 6) eingelötet wird.

9. Montageverfahren nach Anspruch 8, **dadurch gekennzeichnet, dass** das Schwallverfahren mittels eines No Clean Flussmittels der Klasse L0 durchgeführt wird.
